# EUROPEAN PATENT APPLICATION

(11) **EP 2 530 734 A1**
(43) Date of publication of application: **05.12.2012**
(21) Application number: 11737034.6
(22) Date of filing: 26.01.2011
(51) Int. Cl.: H01L 31/042, H01L 31/04

(54) **SOLAR CELL MODULE AND MANUFACTURING METHOD OF SAME**

(30) Priority: 26.01.2010 JP 2010014551
(71) Applicant: Sanyo Electric Co., Ltd., Osaka 570-8677 (JP)
(72) Inventor: YOSHIMINE Yukihiro, Moriguchi-shi Osaka 570-8677 (JP)
(74) Representative: Calderbank, Thomas Roger
(86) International application number: PCT/JP2011/051462
(87) International publication number: WO 2011/093321

(57) **Abstract**

Provided is a solar cell module including a plurality of solar cells connected to one another using wiring members, and achieving high output and high heat resistance. A first solar cell (10d) and a second solar cell (10b, 10c) are electrically connected to each other in such a manner that a conductive member (16a, 16b) made of a metal foil which is of the same type as that of the wiring member (11) and one side portion of a wiring member (11c, 11d) are bonded together using a resin adhesive (12b, 12e) and the other side portion of the wiring member (11c, 11d) and the second solar cell (10b, 10c) are bonded together using a resin adhesive (12c, 12d). A volume content of conductive particles (12B) in the resin adhesive (12b, 12e) is larger than a volume content of conductive particles (12B) in a resin adhesive (12a) bonding the wiring member (11) and the solar cell (10) together.

## Description

### Technical Field

This invention relates to a solar cell module and a manufacturing method of the same. Particularly, this invention relates to a solar cell module including a plurality of solar cells electrically connected to one another using wiring members, and a manufacturing method of the same.

### Background Art

Recently, great attention has been given to solar cell modules as an energy source with small load on an environment.

Typically, a solar cell module includes a plurality of solar cells. The solar cells are electrically connected to one another in series or in parallel using wiring members.

Conventionally, solder has been widely used for bonding a solar cell and a wiring member together. In order to bond the solar cell and the wiring member together using the solder, however, there is a necessity to melt the solder. Consequently, there is a possibility that in a bonding step, the solar cell is heated to high temperature, whereby the solar cell is damaged or becomes deformed.

In view of this, for example, JP 2009-295940 A describes a consideration that a conductive resin adhesive is used for bonding a solar cell and a wiring member together.

### Citation List

### Patent Literature

Patent Literature 1: JP 2009-295940 A

### Summary

### Technical Problem

Incidentally, in a solar cell module manufacturing process, some solar cells are occasionally damaged. In the case where a solar cell is damaged, there is a necessity to exchange the damaged solar cell with a new solar cell.

In order to perform the exchange of the solar cell, typically, wiring members connected to the damaged solar cell are cut, and then the damaged solar cell is removed. Next, a new solar cell is mounted, and the new solar cell and the wiring members left on the solar cells each adjoining to the new solar cell are bonded together using wiring members.

In the case where the solar cell and the wiring member are bonded together using a conductive resin adhesive, typically, it is considered that a conductive resin adhesive which is of the same type as the conductive resin adhesive used for bonding the solar cell and the wiring member together is preferably used for bonding the wiring members together.

As a result of the study eagerly conducted by the inventor of the present invention, however, it has been newly found that a solar cell module, wherein the conductive resin adhesive which is of the same type as the conductive resin adhesive used for bonding the solar cell and the wiring member together is used for bonding the wiring members together, is inferior in output or heat resistance to a solar cell module wherein no solar cell is exchanged.

The present invention has been devised in view of the circumstances described above, and an object thereof is to provide a solar cell module including a plurality of solar cells connected to one another using wiring members, and achieving high output and high heat resistance.

### Solution to Problem

A solar cell module according to an aspect of the present invention includes a plurality of solar cells, a wiring member and a resin adhesive. The wiring member electrically connects between the solar cells. The resin adhesive bonds the wiring member and the solar cell together. The resin adhesive contains a resin and conductive particles dispersed in the resin. The plurality of solar cells includes a first solar cell and a second solar cell adjoining to the first solar cell. The first solar cell has a surface to which the conductive member made of a metal foil is bonded. The first solar cell and the second solar cell are electrically connected to each other in such a manner that the conductive member and one side portion of the wiring member are bonded together using the resin adhesive and the other side portion of the wiring member and the second solar cell are bonded together using the resin adhesive. A volume content of the conductive particles in the resin adhesive bonding the conductive member and the wiring member together is larger than a volume content of the conductive particles in the resin adhesive bonding the wiring member and the solar cell together.

In the solar cell module according to the aspect, it is preferred that the volume content of the conductive particles in the resin adhesive for bonding the conductive member and the wiring member together is not less than 25% by volume.

In the solar cell module according to the aspect, it is preferred that the volume content of the conductive particles in the resin adhesive for bonding the wiring member and the solar cell together is not more than 25% by volume.

In the solar cell module according to the aspect, it is preferred that an average particle diameter of the conductive particles in the resin adhesive for bonding the conductive member and the wiring member together is less than an average particle diameter of the conductive particles in the resin adhesive for bonding the wiring member and the solar cell together. In this case, it is preferred that the average particle diameter of the conductive particles in the resin adhesive for bonding the conductive member and the wiring member together is not more than 5 µm. It is preferred that the average particle diameter of the conductive particles in the resin adhesive for bonding the wiring member and the solar cell together is not less than 5 µm.

In the present invention, the average particle diameter of the conductive particles refers to a value obtained by measuring laser diffraction and scattering through the use of a laser diffraction and scattering particle-size distribution analyzer (LA-700) manufactured by Horiba, Ltd.

In the solar cell module according to the aspect, the wiring member may be bonded to the whole of the solar cell in an arrangement direction of the plurality of solar cells, and the conductive member may be bonded to the whole of the first solar cell in the arrangement direction while the wiring member may be bonded to a part of the conductive member in the arrangement direction.

A manufacturing method of a solar cell module according to an aspect of the present invention includes a first connecting step, an inspecting step and an exchanging step. The first connecting step is a step of electrically connecting a plurality of solar cells using a wiring member by bonding the solar cell and the wiring member together using a resin adhesive containing a resin and conductive particles dispersed in the resin. The inspecting step is a step of inspecting the presence or absence of damage as to each of the connected solar cells. The exchanging step is a step of exchanging a solar cell determined as being damaged in the inspecting step. The exchanging step includes a cutting step and a second connecting step. The cutting step is a step of cutting the wiring member connecting between the solar cell determined as being damaged and the solar cell adjoining to the damaged solar cell. The second connecting step is a step of bonding a new solar cell and one side portion of a new wiring member together using the resin adhesive and bonding the other side portion of the new wiring member and the left wiring member bonded to the solar cell, which has adjoined to the solar cell determined as being damaged, together using the resin adhesive to electrically connect between the new solar cell and the solar cell which has adjoined to the solar cell determined as being damaged. A volume content of the conductive particles in the resin adhesive bonding the other side portion of the wiring member and the left wiring member together is larger than a volume content of the conductive particles in the resin adhesive used in the first connecting step.

In the present invention, the "new solar cell" indicates a solar cell which is not used in the first connecting step, and does not necessarily indicate a brand-new solar cell. Likewise, the "new wiring member" indicates a wiring member which is not used in the first connecting step, and does not necessarily indicate a brand-new wiring member.

In the manufacturing method of the solar cell module according to the aspect, it is preferred that the volume content of the conductive particles in the resin adhesive for bonding the other side portion of the wiring member and the left wiring member together is not less than 25% by volume.

In the manufacturing method of the solar cell module according to the aspect, it is preferred that the volume content of the conductive particles in the resin adhesive used in the first connecting step is not more than 25% by volume.

In the manufacturing method of the solar cell module according to the aspect, it is preferred that an average particle diameter of the conductive particles in the resin adhesive for bonding the other side portion of the wiring member and the left wiring member together is less than an average particle diameter of the conductive particles in the resin adhesive used in the first connecting step.

In the manufacturing method of the solar cell module according to the aspect, it is preferred that the average particle diameter of the conductive particles in the resin adhesive for bonding the other side portion of the wiring member and the left wiring member together is not more than 5 µm.

In the manufacturing method of the solar cell module according to the aspect, it is preferred that the average particle diameter of the conductive particles in the resin adhesive used in the first connecting step is not less than 5 µm.

In the manufacturing method of the solar cell module according to the aspect, in the first connecting step, the wiring member may be bonded to the whole of the solar cell in an arrangement direction of the plurality of solar cells, and in the second connecting step, the one side portion of the new wiring member may be bonded to the whole of the new solar cell in the arrangement direction of the plurality of solar cells while the other side portion of the new wiring member may be bonded to a part, in the arrangement direction, of the left wiring member bonded to the solar cell which has adjoined to the solar cell determined as being damaged.

### Advantageous Effect

According to the present invention, it is possible to provide a solar cell module including a plurality of solar cells connected to one another using wiring members, and achieving high output and high heat resistance.

### Brief Description of Drawings

[Fig. 1]

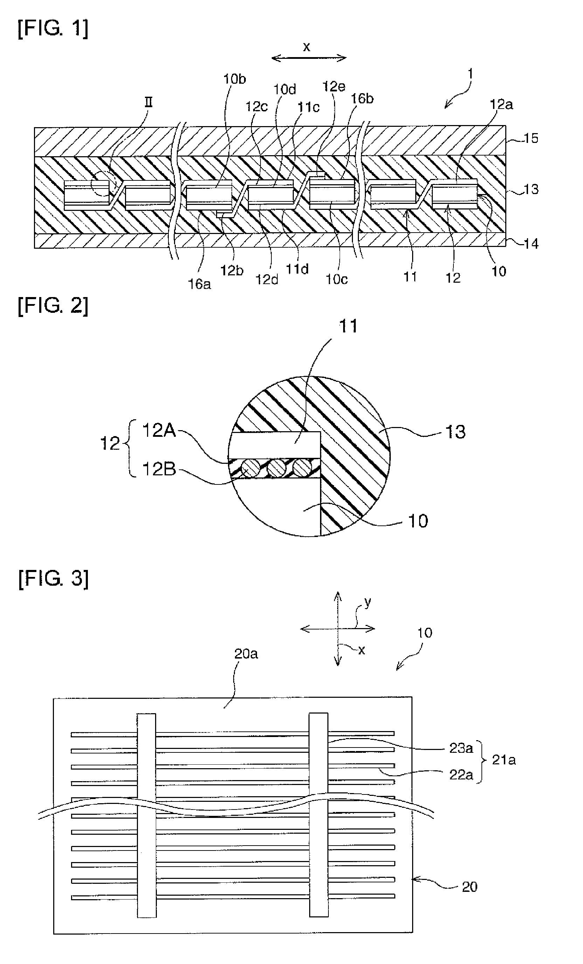

   Fig. 1 is a schematic sectional view of a solar cell module according to one embodiment of the present invention.
[Fig. 2]
   Fig. 2 is a schematic sectional view of a portion II in Fig. 1.
[Fig. 3]
   Fig. 3 is a schematic plan view seen from a light receiving surface side of a solar cell.
[Fig. 4]

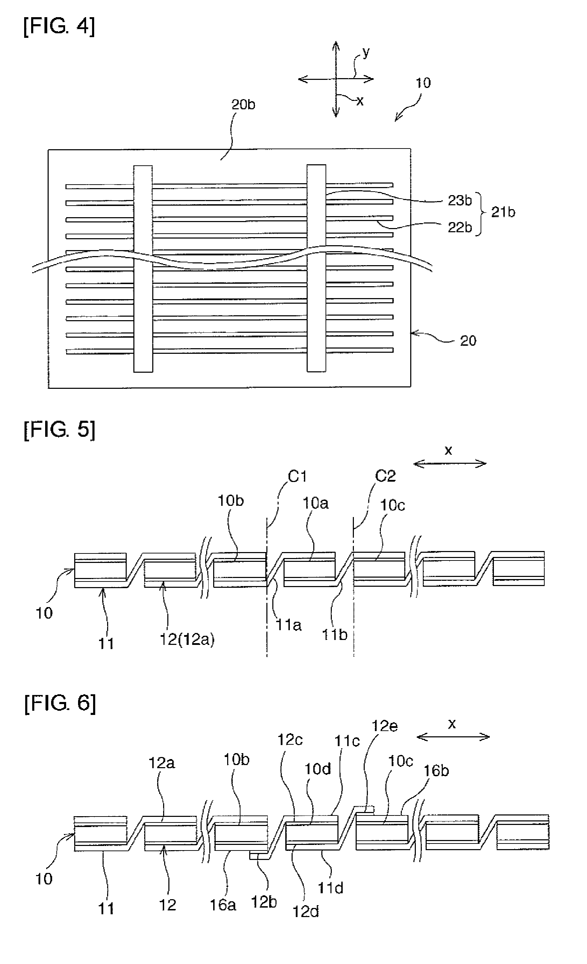

   Fig. 4 is a schematic plan view seen from a rear surface side of the solar cell.
[Fig. 5]
   Fig. 5 is a schematic side view for illustrating a first connecting step.
[Fig. 6]
   Fig. 6 is a schematic side view for illustrating a second connecting step.

### Description of Embodiments

A preferred embodiment of the present invention will be described below with a solar cell module 1 in Fig. 1 taken as an example. However, the solar cell module 1 is merely illustrative. The present invention is not intended to be limited to the solar cell module 1.

Throughout the respective drawings to be referred in the embodiment and the like, moreover, members having substantially identical functions are denoted with identical reference signs. Moreover, the drawings to be referred in the embodiment and the like are schematically made, and the dimensional ratio and the like of a physical object depicted in the drawings occasionally differ from the dimensional ratio and the like of an actual physical object. The respective drawings occasionally differ from one another with regard to the dimensional ratio and the like of a physical object. The dimensional ratio and the like of a specific physical object should be determined in consideration of the following description.

### (Schematic configuration of solar cell module 1)

Fig. 1 is a schematic sectional view of a solar cell module according to one embodiment of the present invention.

As illustrated in Fig. 1, the solar cell module 1 includes a plurality of solar cells 10 arranged along an arrangement direction x. The solar cells 10 are electrically connected to one another using wiring members 11. Specifically, the wiring member 11 electrically connects between the adjoining solar cells 10, so that the solar cells 10 are electrically connected to one another in series or in parallel.

In the present embodiment, the solar cell 10 and the wiring member 11 are bonded together using a conductive resin adhesive 12. The resin adhesive 12 contains a resin 12A and conductive particles 12B dispersed in the resin 12A (see Fig. 2). Moreover, it is preferred that the resin adhesive 12 has anisotropic conductivity.

Examples of a material for the resin 12A in the resin adhesive 12 may include an epoxy resin, an acrylic resin, a polyimide resin, a phenolic resin, a urethane resin, a silicone resin, a mixture or a copolymer of these resins, and the like.

For example, a particle made of a metal such as nickel, copper, silver, aluminum, tin or gold, or an alloy containing one or more kinds of these metals can be used as the conductive particle 12B contained in the resin adhesive 12. Moreover, the conductive particle 12B may be an insulating particle subjected to conductive coating such as metal coating or alloy coating. Examples of the insulating particle may include an inorganic oxide particle, a resin particle and the like. Examples of the inorganic oxide particle may include a particle made of an inorganic oxide such as alumina, silica, titanium oxide or glass. Examples of the resin particle may include a particle made of an epoxy resin, an acrylic resin, a polyimide resin, a phenolic resin, a urethane resin, a silicone resin, a mixture or a copolymer of these resins, or the like.

Moreover, the resin adhesive 12 may contain a different component such as a curing agent.

The shape of the conductive particle 12B is not particularly limited. The conductive particle 12B can take various shapes such as a spherical shape and an ellipsoidal shape.

First and second protection members 14 and 15 are disposed on a light receiving surface side and a rear surface side of the plurality of solar cells 10. A sealant 13 is filled between the first protection member 14 and the second protection member 15. The sealant 13 allows sealing of the plurality of solar cells 10.

Materials for the sealant 13 as well as the first and second protection members 14 and 15 are not particularly limited. For example, the sealant 13 can be made of an ethylene vinyl acetate copolymer (EVA) or a translucent resin such as polyvinyl butyral (PVB).

For example, the first and second protection members 14 and 15 can be formed from glass, resin or the like. Moreover, for example, at least one of the first and second protection members 14 and 15 may be configured with a resin film including a metal foil such as an aluminum foil. In the present embodiment, the first protection member 14 is disposed on the rear surface side of the solar cell 10, and is configured with a resin film including a metal foil such as an aluminum foil. The second protection member 15 is disposed on the light receiving surface side of the solar cell 10, and is made of glass or resin.

### (Structure of solar cell 10)

Fig. 3 is a schematic plan view seen from the light receiving surface side of the solar cell. Fig. 4 is a schematic plan view seen from the rear surface side of the solar cell.

It is noted that the solar cell 10 to be described herein is merely one example. In the present invention, the type and structure of the solar cell are not intended to be limited. For example, the solar cell 10 may be a HIT (registered trademark) solar cell having a HIT structure or may be a solar cell having a different structure.

In the present embodiment, moreover, the solar cell 10 has one main surface serving as a light receiving surface, and the other main surface serving as a rear surface. In the present invention, however, both the main surfaces of the solar cell may be a light receiving surface. In this case, it is preferred that each of the first and second protection members 14 and 15 has a translucent property.

As illustrated in Figs. 3 and 4, the solar cell 10 includes a photoelectric conversion body 20. The photoelectric conversion body 20 receives light, thereby generating carriers (electrons and positive holes).

The photoelectric conversion body 20 is made of a semiconductor material having a semiconductor junction such as a pn junction or a pin junction. Examples of the semiconductor material may include a crystalline silicon semiconductor such as single-crystalline silicon or polycrystalline silicon, an amorphous silicon semiconductor, a compound semiconductor such as GaAs, and the like.

The photoelectric conversion body 20 has a light receiving surface 20a illustrated in Fig. 3 and a rear surface 20b illustrated in Fig. 4. A collector electrode 21a is formed on the light receiving surface 20a, and a collector electrode 21b is formed on the rear surface 20b. The collector electrode 21a includes a plurality of finger electrodes 22a and a bus bar 23a, and the collector electrode 21b includes a plurality of finger electrodes 22b and a bus bar 23b. The pluralities of finger electrodes 22a and 22b mutually extend in parallel in a direction y perpendicular to the arrangement direction x, respectively. The pluralities of finger electrodes 22a and 22b are arranged at predetermined intervals along the arrangement direction x. The bus bars 23a and 23b are formed to extend in the arrangement direction x. The bus bar 23a connects between the finger electrodes 22a, and the bus bar 23b connects between the finger electrodes 22b.

In the solar cell 10, carriers generated by the photoelectric conversion body 20 are acquired by the pluralities of finger electrodes 22a and 22b and collected by the bus bars 23a and 23b.

For example, the collector electrodes 21a and 21b can be formed from a thermosetting conductive paste containing an epoxy resin serving as a binder and a conductive particle serving as a filler. Specifically, the collector electrodes 21a and 21b can be formed by applying the conductive paste in a desired pattern and thermally curing the conductive paste. In the case of forming the collector electrodes 21a and 21b by screen printing, typically, irregularities due to meshes of a screen printing plate are formed on surfaces of the collector electrodes 21a and 21b. Typically, the collector electrodes 21a and 21b each have a surface roughness falling within a range of 1 µm to 8 µm measured by a measuring method using a profilometer based on JIS B0633.

Moreover, for example, the collector electrodes 21a and 21b can be formed from a sintering type paste made of a conductive powder containing silver, aluminum or the like, a glass frit, an organic vehicle and the like. The collector electrodes 21a and 21b can be configured with a metal film made of silver, aluminum or the like, or an alloy film containing one or more kinds of these metals.

### (Manufacturing method of solar cell module 1)

Next, a manufacturing method of the solar cell module 1 will be described with main reference to Figs. 1, 5 and 6.

Fig. 5 is a schematic side view for illustrating a first connecting step. As illustrated in Fig. 5, first, the adjoining solar cells 10 are electrically connected to each other using the wiring member 11, so that the respective solar cells 10 are electrically connected to one another in series or in parallel using the wiring members 11 (first connecting step).

In the first connecting step, the connection between the solar cell 10 and the wiring members 11 is established using the conductive resin adhesive 12. A resin adhesive having anisotropic conductivity is used as the resin adhesive 12. (Hereinafter, the resin adhesive 12 used in the first connecting step is referred to as "a resin adhesive 12a".) Specifically, a paste-like resin adhesive 12a is applied onto the surface of at least one of the bus bar 23a illustrated in Fig. 3 and the wiring member 11, and is also applied onto the surface of at least one of the bus bar 23b illustrated in Fig. 4 and the wiring member 11. Alternatively, a film-like resin adhesive 12a is disposed between the bus bar 23a and the wiring member 11, and is also disposed between the bus bar 23b and the wiring member 11. Thereafter, the wiring members 11 are pressed against the bus bars 23a and 23b, respectively, and the resin adhesive 12a is cured in this state. Thus, the connection between the solar cell 10 and the wiring members 11 is established. In the present embodiment, the wiring member 11 is connected to the whole of the bus bar 23a in the arrangement direction x, and the wiring member 11 is connected to the whole of the bus bar 23b in the arrangement direction x.

Next, an inspecting step is carried out. The inspecting step is a step of inspecting the presence or absence of damage as to each of the solar cells 10 connected in the first connecting step. This inspecting method is not particularly limited and, for example, may be performed by visual inspection.

In the present embodiment, it is assumed in the inspecting step that only a solar cell 10a is determined as being damaged out of the plurality of solar cells 10 illustrated in Fig. 5. That is, in the present embodiment, solar cells 10b and 10c each correspond to a second solar cell. As a matter of course, in the inspecting step, there is a possibility that a plurality of solar cells is determined as being damaged.

Next, the solar cell 10a determined as being damaged in the inspecting step is exchanged (exchanging step). Specifically, the exchanging step includes a cutting step and a second connecting step.

The cutting step is a step of cutting a wiring member 11a connecting between the solar cell 10a determined as being damaged and the solar cell 10b adjoining to the solar cell 10a and a wiring member 11b connecting between the solar cell 10a and the solar cell 10c adjoining to the solar cell 10a. In the present embodiment, in the cutting step, the wiring members 11a and 11b are cut along cutting lines C1 and C2 illustrated in Fig. 5, respectively. As illustrated in Fig. 6, therefore, the wiring member 11a is partially left on the surface of the solar cell 10b, and the wiring member 11b is partially left on the surface of the solar cell 10c. Thus, the conductive member 16a made of a metal foil which is of the same type as that of the wiring member 11 is bonded to the surface of the solar cell 10b, and the conductive member 16b made of a metal foil which is of the same type as that of the wiring member 11 is bonded to the surface of the solar cell 10c. More specifically, the conductive member 16a is connected to the surface of the bus bar 23b formed on the rear surface 20b of the solar cell 10b (see Fig. 4). The conductive member 16b is connected to the whole of the surface, in the arrangement direction x, of the bus bar 23a formed on the light receiving surface 20a of the solar cell 10c (see Fig. 3).

Herein, a cutting method of the wiring members 11a and 11b is not particularly limited. For example, the wiring members 11a and 11b can be cut by a cutting tool such as a cutter.

Subsequent to the cutting step, the second connecting step is carried out. First, the solar cell 10a determined as being damaged is removed. As illustrated in Fig. 6, then, a new solar cell 10d which is not used in the first connecting step is connected to the solar cells 10b and 10c using new wiring members 11c and 11d. In the present embodiment, the solar cell 10d used herein corresponds to a first solar cell.

Specifically, the solar cell 10b and the solar cell 10d are connected to each other in such a manner that one side portion of the wiring member 11c and the conductive member 16a provided on the side of the rear surface 20b of the solar cell 10b are bonded together using a resin adhesive 12b having anisotropic conductivity and the other side portion of the wiring member 11c and the bus bar 23a formed on the light receiving surface 20a of the solar cell 10d are bonded together using a resin adhesive 12c having anisotropic conductivity. The solar cell 10d and the solar cell 10c are connected to each other in such a manner that one side portion of the wiring member 11d and the bus bar 23b formed on the rear surface 20b of the solar cell 10d are bonded together using a resin adhesive 12d having anisotropic conductivity and the other side portion of the wiring member 11d and the conductive member 16b provided on the side of the light receiving surface 20a of the solar cell 10c are bonded together using a resin adhesive 12e having anisotropic conductivity.

In the first connecting step, the wiring member 11 is bonded to substantially the whole of the bus bar 23a in the arrangement direction x, and the wiring member 11 is bonded to substantially the whole of the bus bar 23b in the arrangement direction x. Therefore, the conductive member 16a is bonded to substantially the whole of the solar cell 10b in the arrangement direction x, and the conductive member 16b is bonded to substantially the whole of the solar cell 10c in the arrangement direction x. Also in the second connecting step, the wiring member 11c is bonded to substantially the whole of the bus bar 23a of the solar cell 10d in the arrangement direction x, and the wiring member 11d is bonded to substantially the whole of the bus bar 23b of the solar cell 10d in the arrangement direction x. In the present embodiment, however, the wiring member 11c is connected to only a part of the conductive member 16a in the arrangement direction x, and the wiring member 11d is connected to only a part of the conductive member 16b in the arrangement direction x.

After termination of the second connecting step, a module forming step is carried out. In this step, for example, a resin sheet such as an EVA sheet is placed on the second protection member 15. The plurality of solar cells 10 electrically connected to one another using the wiring members 11 is disposed on the resin sheet. A resin sheet such as an EVA sheet is placed thereon and, further, the first protection member 14 is placed thereon. Under an atmosphere of reduced pressure, these components are subjected to thermocompression bonding so as to be temporarily thermocompressively bonded together, and then are heated again, so that the resin sheets are cured. Through the steps described above, the solar cell module 1 can be manufactured.

If necessary, the solar cell module 1 may be surrounded with a frame made of metal. Moreover, a terminal box may be attached to the surface of the first protection member 14 in order to take a solar cell output out.

In the present embodiment, in the second connecting step, the resin adhesive 12c used for bonding the solar cell 10d and the wiring member 11c together and the resin adhesive 12d used for bonding the solar cell 10d and the wiring member 11d together have the same composition as that of the resin adhesive 12a used in the first bonding step. On the other hand, in the second connecting step, the resin adhesive 12b for bonding the wiring member 11c and the conductive member 16a corresponding to the left wiring member 11a together and the resin adhesive 12e for bonding the wiring member 11d and the conductive member 16b corresponding to the left wiring member 11b together have different composition from that of the resin adhesive 12a used in the first bonding step and the resin adhesives 12c and 12d.

Specifically, a volume content of the conductive particles 12B in the resin adhesives 12b and 12e (see Fig. 2) (a volume of the conductive particles 12B per unit volume of each of the resin adhesives 12b and 12e) is larger than a volume content of the conductive particles 12B in the resin adhesives 12a, 12c and 12d. Specifically, the volume content of the conductive particles 12B in the resin adhesives 12b and 12e is not less than 25% by volume. The volume content of the conductive particles 12B in the resin adhesives 12a, 12c and 12d is not more than 25% by volume. In the case where the volume content of the conductive particles 12B in the resin adhesives 12b and 12e is 25% by volume, the volume content of the conductive particles 12B in the resin adhesives 12a, 12c and 12d is less than 25% by volume.

An upper limit value of the volume content of the conductive particles 12B in the resin adhesives 12b and 12e is not particularly limited, but is preferably 58% by volume, more preferably 55% by volume. A lower limit value of the volume content of the conductive particles 12B in the resin adhesives 12a, 12c and 12d is not particularly limited, but is preferably 1×10⁻⁴% by volume, more preferably 5×10⁻³% by volume.

Further, an average particle diameter of the conductive particles 12B in the resin adhesives 12b and 12e (see Fig. 2) is less than an average particle diameter of the conductive particles 12B in the resin adhesives 12a, 12c and 12d. Specifically, the average particle diameter of the conductive particles 12B in the resin adhesives 12b and 12e is not more than 5 µm. The average particle diameter of the conductive particles 12B in the resin adhesives 12a, 12c and 12d is not less than 5 µm. In the case where the average particle diameter of the conductive particles 12B in the resin adhesives 12b and 12e is 5 µm, the average particle diameter of the conductive particles 12B in the resin adhesives 12a, 12c and 12d is less than 5 µm.

A lower limit value of the average particle diameter of the conductive particles 12B in the resin adhesives 12b and 12e is not particularly limited, but is preferably 0.1 µm, more preferably 1 µm. An upper limit value of the average particle diameter of the conductive particles 12B in the resin adhesives 12a, 12c and 12d is not particularly limited, but is preferably 15 µm, more preferably 10 µm.

As described above, in the present embodiment, the volume content of the conductive particles 12B in the resin adhesive 12b for bonding the wiring member 11c and the conductive member 16a together and the resin adhesive 12e for bonding the wiring member 11d and the conductive member 16b together is larger than the volume content of the conductive particles 12B in the resin adhesive 12a for bonding each of the bus bars 23a and 23b and the wiring member 11a together. Therefore, the solar cell module 1 according to the present embodiment is allowed to achieve high output and high heat resistance.

Moreover, at the time of bonding the wiring member 11c and the conductive member 16a together and bonding the wiring member 11d and the conductive member 16b together, even in the case where a pressure to be applied between the wiring member 11c and the conductive member 16a and between the wiring member 11d and the conductive member 16b is set to be small, it is possible to appropriately bond the wiring member 11c and the conductive member 16a together and to appropriately bond the wiring member 11d and the conductive member 16b together. Accordingly, it is possible to prevent the solar cell 10 from being damaged in the second bonding step. Accordingly, it is possible to manufacture the solar cell 10 with high efficiency percentage.

Specifically, in the present embodiment, the volume content of the conductive particles 12B in the resin adhesives 12b and 12e is not less than 25% by volume. The volume content of the conductive particles 12B in the resin adhesive 12a is not more than 25% by volume. Accordingly, it is possible to achieve both of high output and high heat resistance.

Further, the average particle diameter of the conductive particles 12B in the resin adhesives 12b and 12e is less than the average particle diameter of the conductive particles 12B in the resin adhesive 12a. Specifically, the average particle diameter of the conductive particles 12B in the resin adhesives 12b and 12e is not more than 5 µm. The average particle diameter of the conductive particles 12B in the resin adhesive 12a is not less than 5 µm. Accordingly, it is possible to achieve both of higher output and higher heat resistance.

In the present embodiment, the description is given of the example that the conductive members 16 are bonded to the surfaces of some of the solar cell 10. However, the present invention is not limited to this configuration. For example, the conductive members 16 may be bonded to the surfaces of all the solar cells 10.

### <<Experimental Example 1>>

The foregoing advantageous effects will be specifically described below on the basis of examples of actually conducted experiments.

In the present experimental example, the solar cell module 1 according to the foregoing embodiment was prepared with the HIT type solar cell 10 in accordance with the method described in the foregoing embodiment. In the present experimental example, however, the solar cell module 1 was prepared such that none of the solar cells 10 was damaged in the first connecting step and the solar cell 10a at a specific position out of the plurality of solar cells 10 was exchanged with the new solar cell 10d in the exchanging step.

A copper foil having both surfaces on which a solder layer made of Sn-Ag-Cu and having a maximum thickness of 40 µm is formed (a thickness: 150 µm, a width: 1 mm) was used as the wiring member 11.

A paste-like adhesive in which conductive particles 12B as Ni particles are dispersed in an epoxy-based resin 12A was used as the conductive resin adhesive 12. The resin adhesive 12 was applied onto the bus bars 23a and 23b through the use of a dispenser so as to have a thickness of 20 µm, a width of 1 mm and a length of 98 mm, and the wiring member 11 was disposed thereon. Thereafter, a metal tool heated to 200°C was pressed with a force of 200 N for 30 seconds, so that the solar cell 10 and the wiring member 11 were bonded together. The connection between each of the wiring members 11c and 11d and the solar cell 10d was also established in a similar manner.

When the metal tool was pressed with the force of 200 N, a pressure of about 2 MPa was applied to the wiring member 11.

On the other hand, the connection between the conductive member 16a and the wiring member 11c and the connection between the conductive member 16b and the wiring member 11d were established as follows. That is, the paste-like resin adhesive 12b was applied onto the conductive member 16a and the paste-like resin adhesive 12e was applied onto the conductive member 16b through the use of the dispenser such that the resin adhesives 12b and 12e have a thickness of 30 µm, a width of 1 mm and a length of 10 mm. Then, the wiring member 11c was disposed on the resin adhesive 12b and the wiring member 11d was disposed on the resin adhesive 12e. Thereafter, the metal tool heated to 200°C was pressed with a force of 1 N for 30 seconds, so that the conductive member 16a and the wiring member 11c were bonded together and the conductive member 16b and the wiring member 11d were bonded together. It is noted that a resin component of each of the resin adhesives 12b and 12e at this time is the same as that of the resin adhesive 12 applied onto the bus bars 23a and 23b.

When the metal tool was pressed with the force of 1 N, a pressure of almost 0.1 MPa was applied to the wiring members 11c and 11d.

Moreover, the prepared solar cell module 1 was evaluated in accordance with the following method.

### (Evaluation of output change)

The exchanging step was carried out after measuring output from a unit including the plurality of solar cells 10 before carrying out the cutting step (output before exchange). Thereafter, output from the prepared solar cell module 1 (output after exchange) was measured, and an output ratio ((output after exchange)/(output before exchange)) was calculated. Herein, the measurement of the output was performed under pseudo sunlight from a solar simulator.

### (Evaluation of heat resistance)

Evaluation of heat resistance was made in accordance with an evaluation method based on JIS C8992. Specifically, a cycle of heating the prepared solar cell module 1 from -40°C to 90°C over 90 minutes, holding the prepared solar cell module 1 at 90°C for 20 minutes, cooling the prepared solar cell module 1 from 90°C to -40°C over 90 minutes and holding the prepared solar cell module 1 at -40°C for 30 minutes was performed 400 times. After performing the cycle 400 times, output from the solar cell module 1 was measured, and a ratio of output after conducting the heat resistance test to output before conducting the heat resistance test (corresponding to the output after exchange) ((output after conducting heat resistance test) / (output before conducting heat resistance test)) was calculated.

Data shown in Table 1 below are data obtained by preparing and evaluating the solar cell module 1 while variously changing the volume content of the conductive particles 12B in the resin adhesive 12b used for connecting the conductive member 16a and the wiring member 11c in the second connecting step and the resin adhesive 12e used for connecting the conductive member 16b and the wiring member 11d in the second connecting step. Herein, an adhesive containing conductive particles 12B having an average particle diameter of 7 µm and a volume content of 1×10⁻²% was used as the resin adhesive 12a used in the first connecting step. Moreover, the average particle diameter of the conductive particles 12B in the resin adhesives 12b and 12e was set to 2 µm.

**Table 1**

| Volume content of conductive particles 12B in conductive adhesives 12b and 12e (% by volume) | (Output after exchange)/ (output before exchange) | (Output after conducting heat resistance test)/ (output before conducting heat resistance test) |
|---|---|---|
| 5×10⁻³ | 98.2% | 99.5% |
| 10 | 99.2% | 99.6% |
| 20 | 99.4% | 99.5% |
| 25 | 99.8% | 99.4% |
| 30 | 100% | 99.5% |
| 40 | 100% | 99.6% |
| 55 | 99.8% | 99.2% |

Data shown in Table 2 below are data obtained by preparing and evaluating the solar cell module 1 while variously changing the volume content of the conductive particles 12B in the resin adhesive 12a used in the first connecting step. Herein, an adhesive containing conductive particles 12B having an average particle diameter of 2 µm and a volume content of 50% was used as the resin adhesives 12b and 12e. Moreover, the average particle diameter of the conductive particles 12B in the resin adhesive 12a used in the first connecting step was set to 7 µm.

**Table 2**

| Volume content of conductive particles 12B in conductive adhesive 12a (% by volume) | (Output after exchange)/ (output before exchange) | (Output after conducting heat resistance test)/ (output before conducting heat resistance test) |
|---|---|---|
| 5×10⁻³ | 100% | 99.5% |
| 1 | 100% | 99.4% |
| 10 | 100% | 99.5% |
| 20 | 100% | 99.5% |
| 25 | 100% | 99.3% |
| 30 | 100% | 98.2% |
| 35 | 100% | 95.3% |

Data shown in Table 3 below are data obtained by preparing and evaluating the solar cell module 1 while variously changing the average particle diameter of the conductive particles 12B in the resin adhesive 12b used for connecting the conductive member 16a and the wiring member 11c in the second connecting step and the resin adhesive 12e used for connecting the conductive member 16b and the wiring member 11d in the second connecting step. Herein, an adhesive containing conductive particles 12B having an average particle diameter of 7 µm and a volume content of 1×10⁻²% was used as the resin adhesive 12 used in the first connecting step. Moreover, the volume content of the conductive particles 12B in the resin adhesives 12b and 12e was set to 30% by volume.

**Table 3**

| Average particle diameter of conductive particles 12B in conductive adhesives 12b and 12e (µm) | (Output after exchange)/ (output before exchange) | (Output after conducting heat resistance test)/ (output before conducting heat resistance test) |
|---|---|---|
| 1 | 100% | 99.6% |
| 3 | 100% | 99.5% |
| 5 | 99.8% | 99.6% |
| 7 | 99.4% | 99.5% |
| 10 | 98.8% | 99.5% |

Data shown in Table 4 below are data obtained by preparing and evaluating the solar cell module 1 while variously changing the average particle diameter of the conductive particles 12B in the resin adhesive 12a used in the first connecting step. Herein, an adhesive containing conductive particles 12B having an average particle diameter of 2 µm and a volume content of 50% was used as the resin adhesives 12b and 12e. Moreover, the volume content of the conductive particles 12B in the resin adhesive 12a used in the first connecting step was set to 1×10⁻²% by volume.

**Table 4**

| Average particle diameter of conductive particles 12B in conductive adhesive 12a (µm) | (Output after exchange)/ (output before exchange) | (Output after conducting heat resistance test)/ (output before conducting heat resistance test) |
|---|---|---|
| 1 | 98.2% | 98.3% |
| 3 | 99.0% | 99.1% |
| 5 | 99.8% | 99.3% |
| 7 | 100% | 99.5% |
| 10 | 100% | 99.5% |

It is apparent from the results shown in Table 1 above that the (output after exchange)/(output before exchange) tended to decrease as the volume content of conductive particles 12B in the resin adhesive 12b used for connecting between the conductive member 16a and the wiring member 11c in the second connecting step and the resin adhesive 12e used for connecting between the conductive member 16b and the wiring member 11d in the second connecting step was set to be small. Specifically, in the case where the volume content of the conductive particles 12B in the resin adhesives 12b and 12e was not less than 25% by volume, the (output after exchange) / (output before exchange) did not change so much even when the volume content of the conductive particles 12B was changed. On the other hand, in the case where the volume content of the conductive particles 12B in the resin adhesives 12b and 12e was less than 25% by volume, the (output after exchange) / (output before exchange) tended to decrease as the volume content of the conductive particles 12B was set to be small.

The heat resistance did not change largely even when the volume content of the conductive particles 12B in the resin adhesives 12b and 12e was changed.

It is apparent from the results shown in Table 2 above that the (output after exchange) / (output before exchange) did not change even when the volume content of the conductive particles 12B in the resin adhesive 12a used in the first connecting step was changed. On the other hand, the heat resistance tended to decrease as the volume content of the conductive particles 12B in the resin adhesive 12a was set to be large. Specifically, in the case where the volume content of the conductive particles 12B in the resin adhesive 12a was not more than 25% by volume, the heat resistance did not change even when the volume content of the conductive particles 12B was changed. However, it is apparent that the volume content of the conductive particles 12B increases and the heat resistance decreases in the case where the volume content of the conductive particles 12B in the resin adhesive 12a is larger than 25% by volume.

It is apparent from the results described above that it is difficult to achieve both of high output and high heat resistance in the case where the resin adhesives 12b and 12e are equal to the resin adhesive 12a with regard to the volume content of the conductive particles 12B. Specifically, it is apparent that it becomes difficult to achieve high output in the case where the volume content of the conductive particles 12B in the resin adhesives 12b and 12e is less than 25% by volume and, on the other hand, it becomes difficult to realize high heat resistance in the case where the volume content of the conductive particles 12B in the resin adhesive 12a is larger than 25% by volume.

Moreover, it is apparent that it is possible to achieve both of high output and high heat resistance when the volume content of the conductive particles 12B in the resin adhesives 12b and 12e is set to be larger than the volume content of the conductive particles 12B in the resin adhesive 12a. Specifically, it is apparent that it is possible to achieve both of high output and high heat resistance when the volume content of the conductive particles 12B in the resin adhesives 12b and 12e is set to be not less than 25% by volume, the volume content of the conductive particles 12B in the resin adhesive 12a is set to be not more than 25% by volume and the volume content of the conductive particles 12B in the resin adhesives 12b and 12e is set to be larger than the volume content of the conductive particles 12B in the resin adhesive 12a.

Moreover, it is apparent from the results shown in Table 3 that the heat resistance does not change so much even when the average particle diameter of the conductive particles 12B in the resin adhesives 12b and 12e is changed. On the other hand, it is apparent that the (output after exchange) / (output before exchange) decreases as the average particle diameter of the conductive particles 12B in the resin adhesives 12b and 12e is set to be large. Specifically, it is apparent that in the case where the average particle diameter of the conductive particles 12B in the resin adhesives 12b and 12e is not more than 5 µm, the (output after exchange) / (output before exchange) does not change largely even when the average particle diameter of the conductive particles 12B in the resin adhesives 12b and 12e is changed. However, it is apparent that in the case where the average particle diameter of the conductive particles 12B in the resin adhesives 12b and 12e is larger than 5 µm, the (output after exchange)/(output before exchange) decreases as the average particle diameter of the conductive particles 12B in the resin adhesives 12b and 12e is set to be large.

It is apparent from the results shown in Table 4 that both the (output after exchange)/(output before exchange) and the heat resistance decrease as the average particle diameter of the conductive particles 12B in the resin adhesive 12a is set to be small. Specifically, in the case where the average particle diameter of the conductive particles 12B in the resin adhesive 12a is not less than 5 µm, each of the (output after exchange) / (output before exchange) and the heat resistance does not change largely even when the average particle diameter of the conductive particles 12B in the resin adhesive 12a is changed. On the other hand, it is apparent that in the case where the average particle diameter of the conductive particles 12B in the resin adhesive 12a is less than 5 µm, both the (output after exchange)/(output before exchange) and the heat resistance decrease as the average particle diameter of the conductive particles 12B in the resin adhesive 12a is set to be small.

It is apparent from the results described above that it is possible to obtain the solar cell module 1 achieving higher output and higher heat resistance by setting the average particle diameter of the conductive particles 12B in the resin adhesives 12b and 12e to be less than the average particle diameter of the conductive particles 12B in the resin adhesive 12a. Specifically, it is apparent that it is possible to achieve both of higher output and higher heat resistance by setting the average particle diameter of the conductive particles 12B in the resin adhesives 12b and 12e to be not more than 5 µm, setting the average particle diameter of the conductive particles 12B in the resin adhesive 12a to be not less than 5 µm and setting the average particle diameter of the conductive particles 12B in the resin adhesives 12b and 12e to be less than the average particle diameter of the conductive particles 12B in the resin adhesive 12a.

### «Experimental Example 2»

A solar cell module 1 was prepared and evaluated in similar manners to those in the foregoing experimental example except that the solar cell 10 and the wiring member 11 were bonded together by using solder made of an SnAgCu alloy in place of the resin adhesive 12, pressing the wiring member 11 with a force of 1 N and heating the solder to 250°C. As the result, the (output after exchange) / (output before exchange) was 99.5%, and the output ratio ((output after conducting heat resistance test)/(output before conducting heat resistance test)) was 98.3%. It is apparent from this result that it is possible to realize high output and high heat resistance by using the resin adhesive 12 for bonding the solar cell 10 and the wiring member 11 together as in the present embodiment.

It is preferred that in the second connecting step, in the second connecting step, a curing temperature of the resin adhesive 12b for bonding the wiring member 11c and the conductive member 16a corresponding to the left wiring member 11a together and the resin adhesive 12e for bonding the wiring member 11d and the conductive member 16b corresponding to the left wiring member 11b together is lower than a curing temperature of the resin adhesive 12a used in the first bonding step and the resin adhesives 12c and 12d. With this setting, it is possible to prevent the decrease of adhesion strength between the conductive member 16a and the bus bar 23b at the time of bonding the wiring member 11c and the conductive member 16a together in the second connecting step and adhesion strength between the conductive member 16b and the bus bar 23a at the time of bonding the wiring member 11d and the conductive member 16b together in the second connecting step.

Typically, a curing temperature of a resin adhesive can be optionally determined how blended a curing agent is. For example, Table 5 shows results obtained in the case of using a conductive adhesive manufactured by Diemat, Inc. As shown in this table, it is preferred that conductive pastes which are different in curing temperature from one another may be selectively used by appropriately adjusting the type and amount of a curing agent to be blended in a resin adhesive.

**Table 5**

| | DM5130P | | DM6030Hk | DM6030Hk-PT | | DM6030SF |
|---|---|---|---|---|---|---|
| Resin type | Thermosetting | | Thermosetting (epoxy) | | | |
| Linear expansion coefficient (ppm/°C) | 23 | | 26 | 26 | | 26 |
| Curing temperature and time | | | | 165°C | 60 min. | |
| | 175°C | 10-45 min. | | 175°C | 30 min. | |
| | 200°C | 5-30 min. | | 200°C | 15-30 min. | |

### Reference Signs List

1 ... Solar cell module
10 ... Solar cell
10a ... Solar cell determined as being damaged in inspecting step
10b, 10c ... Second solar cell
10d ... First solar cell
11 ... Wiring member
11c, 11d ... New wiring member
12 ... Resin adhesive
12a ... Resin adhesive for bonding wiring member and solar cell together
12b, 12c ... Resin adhesive for bonding conductive member and wiring member together
12A ... Resin
12B ... Conductive particle
16a, 16b ... Conductive member

## Claims

1. A solar cell module comprising:
a plurality of solar cells;
a wiring member electrically connecting between the solar cells; and
a resin adhesive bonding the wiring member and the solar cell together, the resin adhesive containing a resin and conductive particles dispersed in the resin, wherein
the plurality of solar cells includes a first solar cell and a second solar cell adjoining to the first solar cell,
the first solar cell has a surface to which the conductive member made of a metal foil is bonded,
the first solar cell and the second solar cell are electrically connected to each other in such a manner that the conductive member and one side portion of the wiring member are bonded together using the resin adhesive and the other side portion of the wiring member and the second solar cell are bonded together using the resin adhesive, and
a volume content of the conductive particles in the resin adhesive bonding the conductive member and the wiring member together is larger than a volume content of the conductive particles in the resin adhesive bonding the wiring member and the solar cell together.

2. The solar cell module according to claim 1, wherein
the volume content of the conductive particles in the resin adhesive bonding the conductive member and the wiring member together is not less than 25% by volume.

3. The solar cell module according to claim 1 or 2, wherein
the volume content of the conductive particles in the resin adhesive bonding the wiring member and the solar cell together is not more than 25% by volume.

4. The solar cell module according to claim 1, wherein
an average particle diameter of the conductive particles in the resin adhesive bonding the conductive member and the wiring member together is less than an average particle diameter of the conductive particles in the resin adhesive bonding the wiring member and the solar cell together.

5. The solar cell module according to claim 4, wherein
the average particle diameter of the conductive particles in the resin adhesive bonding the conductive member and the wiring member together is not more than 5 µm.

6. The solar cell module according to claim 4 or 5, wherein
the average particle diameter of the conductive particles in the resin adhesive bonding the wiring member and the solar cell together is not less than 5 µm.

7. The solar cell module according to claim 1, wherein
the wiring member is bonded to the whole of the solar cell in an arrangement direction of the plurality of solar cells, and
the conductive member is bonded to the whole of the first solar cell in the arrangement direction while the wiring member is bonded to a part of the conductive member in the arrangement direction.

8. The solar cell module according to claim 1, wherein
the resin adhesive has anisotropic conductivity.

9. A manufacturing method of a solar cell module, comprising:
a first connecting step of electrically connecting a plurality of solar cells using a wiring member by bonding the solar cell and the wiring member together using a resin adhesive containing a resin and conductive particles dispersed in the resin;
an inspecting step of inspecting the presence or absence of damage as to each of the connected solar cells; and
an exchanging step of exchanging a solar cell determined as being damaged in the inspecting step, wherein
the exchanging step includes:
a cutting step of cutting the wiring member connecting between the solar cell determined as being damaged and the solar cell adjoining to the damaged solar cell; and
a second connecting step of bonding a new solar cell and one side portion of a new wiring member together using the resin adhesive and bonding the other side portion of the new wiring member and the left wiring member bonded to the solar cell, which has adjoined to the solar cell determined as being damaged, together using the resin adhesive to electrically connect between the new solar cell and the solar cell which has adjoined to the solar cell determined as being damaged, and
a volume content of the conductive particles in the resin adhesive bonding the other side portion of the wiring member and the left wiring member together is larger than a volume content of the conductive particles in the resin adhesive used in the first connecting step.

10. The manufacturing method of the solar cell module according to claim 9, wherein
the volume content of the conductive particles in the resin adhesive bonding the other side portion of the wiring member and the left wiring member together is not less than 25% by volume.

11. The manufacturing method of the solar cell module according to claim 9 or 10, wherein
the volume content of the conductive particles in the resin adhesive used in the first connecting step is not more than 25% by volume.

12. The manufacturing method of the solar cell module according to claim 9, wherein
an average particle diameter of the conductive particles in the resin adhesive bonding the other side portion of the wiring member and the left wiring member together is less than an average particle diameter of the conductive particles in the resin adhesive used in the first connecting step.

13. The manufacturing method of the solar cell module according to claim 12, wherein
the average particle diameter of the conductive particles in the resin adhesive bonding the other side portion of the wiring member and the left wiring member together is not more than 5 µm.

14. The manufacturing method of the solar cell module according to claim 12 or 13, wherein
the average particle diameter of the conductive particles in the resin adhesive used in the first connecting step is not less than 5 µm.

15. The manufacturing method of the solar cell module according to claim 9, wherein
in the first connecting step, the wiring member is bonded to the whole of the solar cell in an arrangement direction of the plurality of solar cells, and
in the second connecting step, the one side portion of the new wiring member is bonded to the whole of the new solar cell in the arrangement direction of the plurality of solar cells while the other side portion of the new wiring member is bonded to a part, in the arrangement direction, of the left wiring member bonded to the solar cell which has adjoined to the solar cell determined as being damaged.

16. The manufacturing method of the solar cell module according to claim 9, wherein
the resin adhesive has anisotropic conductivity.
